# EUROPEAN PATENT APPLICATION

(11) **EP 4 801 210 A1**
(43) Date of publication of application: **02.09.2026**
(21) Application number: 25160220.7
(22) Date of filing: 26.02.2025
(51) Int. Cl.: H05K 7/20

(54) **ELECTRIC POWER CONVERTER AND ELECTRIC APPLIANCE**

(71) Applicant: Hitachi Energy Ltd, 8050 Zürich (CH)
(72) Inventor: George, Robin, 31-445 Krakow (PL); Ruszczyk, Adam, 30-316 Krakow (PL); Sowa, Kacper, 33-342 Krakow (PL)
(74) Representative: Epping - Hermann - Fischer

(57) **Abstract**

An electric power converter (1) comprising an enclosure (2) and a plurality of devices (3) that generate heat during operation and are located inside the enclosure (2), wherein
- and enclosure (2) comprises an air inlet opening (21) and an air outlet opening (22),
- the enclosure (2) is airtight except for the air inlet opening (21) and the air outlet opening (22),
- the air inlet opening (21) is configured to be connected to an air mover (41) creating a positive pressure,
- an air distribution manifold (51) is located inside the enclosure (2) and connected to the air inlet opening (21), and
- the air distribution manifold (51) has air openings (6) directed towards the devices (3).

Further, an electric appliance (10) is specified.

## Description

The present disclosure relates to an electric power converter and to an electric appliance.

Electric power converters may be cooled during operation by fans for example. However, it is difficult to cool the components using traditional fans when they are tightly packed for higher power density. Further, the use of fans may compromise ingress protection for water and the acoustic signature of the converter.

Embodiments of the disclosure relate to ways for improved cooling.

According to an embodiment, an electric power converter comprises an enclosure and a plurality of devices that generate heat during operation and are located inside the enclosure. The enclosure comprises an air inlet opening and an air outlet opening and is airtight except for the air inlet opening and the air outlet opening. The air inlet opening is configured to be connected to an air mover creating a positive pressure. An air distribution manifold is located inside the enclosure and connected to the air inlet opening. The air distribution manifold has air openings directed towards the devices that generate heat.

During operation of the electric power converter, the air distribution manifold with the air openings allows the air flow to be directed onto the devices that may produce hot spots within the electric power converter in a controlled manner.

For example, the air mover may comprise a fan, a blower or a compressor or a combination thereof. Due to the positive pressure within the air distribution manifold with respect to the enclosure, the air blown into the air inlet opening exits through the air openings of the air distribution manifold to cool the devices.

If the air mover comprises a compressor, the cooling efficiency within the enclosure may be further improved by utilizing the cooling effect of expanding air.

The device may be any active or passive component creating heat during operation of the electric power converter. For example, the device is an electric or electronic device, an integrated circuit, a magnetic circuit, a coil, or a busbar.

For example, the air inlet opening is connected to the air mover via a hose. This helps to facilitate the protection of the devices within the enclosure from water and dust.

Compared to a conventional cooling via fans, the devices creating hotspots within the electric power converter may be cooled directly in a controllable manner. This helps to obtain efficient cooling, even for higher power densities.

During production of the electric power converter, the described way of cooling gives more flexibility in the placement of the devices generating heat as any location within the enclosure may be efficiently cooled by the provision of appropriate air openings.

Thus, the arrangement of the components within the electric power converter can be optimized for higher efficiency, shorter electric connections and/or a higher power density. Based on the optimized arrangement, the air distribution manifold may be configured such that each of the devices that may cause a hotspot can be provided with the required air flow rate for sufficient cooling.

Further, a lower total air flow may be sufficient to obtain a reliable cooling of all hotspots occurring within the enclosure of the electric power converter.

This may also help to reduce noise during operation of the electric power converter.

For example, the air distribution manifold may comprise a plurality of branches, wherein each branch may comprise one or more air openings. The air flow rate through each branch of the air distribution manifold may be controlled by means of a valve or a specifically adapted cross-section of the branch, for instance. Likewise, the size of the air openings and/or the shape of the air openings may be selected such that the required cooling is obtained at the position of the devices that generate heat during operation.

According to a further embodiment of the electric power converter, the air outlet opening is configured to be connected to a further air mover, creating a negative pressure. Thus, the further air mover may help to remove the hot air from the enclosure and to increase the air flow through the enclosure of the electric power converter.

According to a further embodiment of the electric power converter, an air collector manifold is placed inside the enclosure and connected to the air outlet opening. The air collector manifold may be designed to control the air flow within the electric power converter and/or to efficiently collect the hot air within the enclosure.

According to a further embodiment of the electric power converter, at least a portion of the air distribution manifold is formed in a wall of the enclosure. The term "wall" does not imply any limitation with respect to the orientation in space. For example, the wall is side wall or a top plate of the enclosure. Further, at least a portion of the air collector manifold may be formed in a wall of the enclosure if present. For example, the wall of the enclosure is made from a plastics material.

Alternatively or in addition, a portion of the air distribution manifold and/or of the air collector manifold may be formed separately, for example by a separate component comprising a metal or a plastics material.

According to a further embodiment of the electric power converter, the electric power converter is free of fans located within the enclosure. This helps to reduce the thickness of the airtight enclosure and helps to improve the power density. However, the electric power converter may comprise one or more fans located outside the enclosure or in other parts of the enclosure.

According to a further embodiment of the electric power converter, the electric power converter comprises a section located outside the enclosure or as a separate part of the enclosure. For example, the section may comprise components that are less sensitive to water or dust ingress. Alternatively or in addition, the section may be configured to additionally cool devices of the electric power converter located within the airtight enclosure via heat conduction.

According to a further embodiment of the electric power converter, the section comprises an active cooling device located outside the enclosure. For example, the active cooling device comprises a fan or a cooler comprising a fluid.

Further, an electric appliance is specified, wherein the electric appliance comprises a cabinet and at least one electric power converter described above, wherein the at least one electric power converter is arranged in the cabinet. The electric appliance further comprises an air mover connected to the air inlet opening of the electric power converter. The air mover may be located within the cabinet or outside the cabinet of the electric appliance.

Optionally, the electric appliance may comprise a further air mover connected to the air outlet opening of the electric power converter.

According to a further embodiment of the electric appliance, the air mover is part of an open loop air cooling system. Thus, the air mover continuously provides fresh air to the air inlet opening.

According to a further embodiment of the electric appliance, the open loop air cooling system comprises a conditioned air space. The conditioned air space may be used to provide the air mover with conditioned and/or cooled air.

According to a further embodiment of the electric appliance, the air mover is part of a closed loop air cooling system.

For example, a conditioned air space may be used to cool the air before it is fed to the air inlet opening of the electric power converter.

According to a further embodiment of the electric appliance, the closed loop air cooling system comprises a heat exchanger. By means of the heat exchanger, the hot air coming from the electric power converter is cooled before it is fed back to the air inlet of the electric power converter.

According to a further embodiment of the electric appliance, the electric appliance comprises a further electric power converter with a further air inlet opening, wherein the air inlet opening of the electric power converter and the further air inlet opening of the further electric power converter are connected to the air mover. Thus, a common air mover may be used for two or more electric power converters.

Consequently, two or more electric power converters of the electric appliance may be cooled during operation using the same air mover. For example, the air inlet of the electric power converter and the air inlet of the further electric power converter may be connected to the common air mover via an air inlet manifold. For example, the air inlet manifold may be located at least in part within the cabinet.

Alternatively, the electric power converters of the electric appliance may be connected to a common air mover via separate hoses.

By protecting the air mover's inlet from water ingression, all electric power converters of the electric appliance can be indirectly protected from water ingression. Further the quality of the air provided to the electric power converters can be easily controlled since only one global air inlet is required for all electric power converters of the electric appliance.

When compared with liquid cooled systems, the approach described above eliminates water leakage issues with respect to the devices located within the enclosure. In particular, air can be blown directly onto the devices that generate heat whereas a liquid based cooling system requires a heat exchanger such as a cold plate in thermal contact with the devices.

However, the electric appliance may comprise a water cooling system located outside the enclosures of the electric power converters in order to cool the air, for example. Together with a self-cooling effect by expansion, precooling the air may significantly lower the air temperature inside the enclosure of the electric power converter.

According to a further embodiment of the electric appliance, the electric appliance is configured to provide the air inlet opening of the electric power converter with conditioned air. For example, the air may be dried if the electric appliance is located in a humid environment.

According to a further embodiment of the electric appliance, the electric appliance is configured to provide the air inlet opening of the electric power converter with compressed air. For example, the air mover comprises a compressor to provide the compressed air. The expansion of the compressed air within the enclosure may further improve the cooling efficiency.

Features described above in connection with an embodiment of the electric power converter or of the electric appliance may be combined with features described in connection with other embodiments of the electric power converter or the electric appliance unless they are contradictory.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.

In the Figures:
Figures 1A and 1B show an exemplary embodiment of an electric power converter in a perspective view (Figure 1A) and in a side view (Figure 1B),
Figure 1C shows a schematic representation of an electric power converter according to an exemplary embodiment;
Figure 2A shows a schematic representation of an electric appliance according to an exemplary embodiment;
Figure 2B shows a schematic representation of an electric appliance according to an exemplary embodiment;
Figure 3 shows a schematic representation of an electric appliance according to an exemplary embodiment;
Figure 4 shows a schematic representation of an electric appliance according to an exemplary embodiment;
Figure 5 shows a schematic representation of an electric appliance according to an exemplary embodiment; and
Figure 6 shows a schematic representation of an electric appliance according to an exemplary embodiment.

While the disclosure is amenable to various modifications and alternative forms, specifics thereof have been shown by way of example in the figures and will be described in detail. It should be understood, however, that the intention is not to limit the disclosure to the particular embodiments described. On the contrary, the intention is to cover all modifications, equivalents, and alternatives falling within the scope of the disclosure defined by the appended claims.

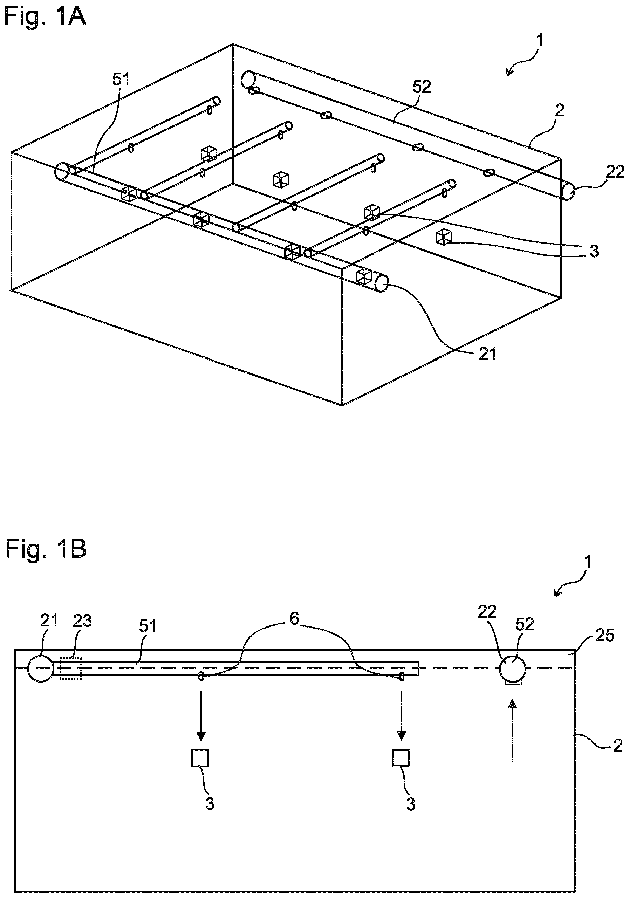

The electric power converter 1 illustrated in Figures 1A and 1B comprises an enclosure 2 and a plurality of devices 3 that generate heat during operation. The devices 3 are located inside the enclosure 2. The enclosure 2 comprises an air inlet opening 21 and an air outlet opening 22. Except for these openings, the enclosure 2 is airtight. The air inlet opening 21 is configured to be connected to an air mover 41 creating a positive pressure. The electric power converter 1 further comprises an air distribution manifold 51 located inside the enclosure 2 and connected to the air inlet opening 21. The air distribution manifold 51 has air openings 6 directed towards the devices 3.

Optionally, the air outlet opening 22 may be connected to an air collector manifold 52 placed inside the enclosure 2.

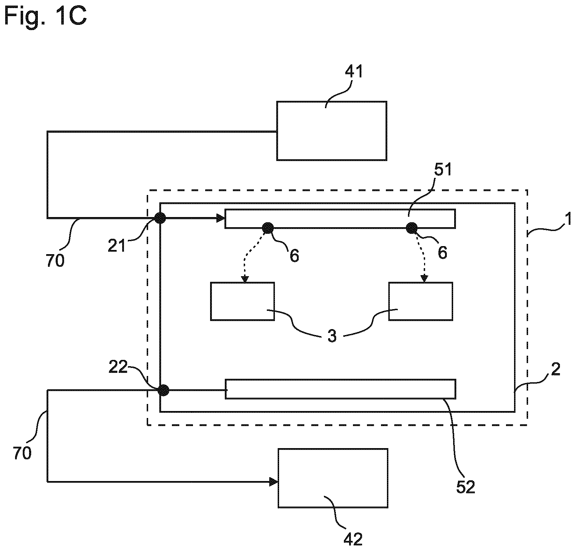

In the schematic representation of Figure 1C, the air mover 41 connected to the air inlet opening 21 and the further air mover 42 connected to the air outlet opening 22 are located outside the enclosure 2 of the electric power converter 1. The further air mover 42 may be used to create negative pressure so that the air flow through the enclosure 2 is increased. However, the further air mover 42 may also be omitted. In this case, the positive pressure created within the enclosure 2 with respect to the environment may prevent an ingress of dust or other particles into the enclosure.

In the exemplary embodiment of Figure 1A, the air distribution manifold 51 has a plurality of branches forming a comb-like structure. However, other structures may also be used. The air flow rate through each branch of the air distribution manifold 51 or the air openings 6 can be controlled by means of an optional valve 23 (cf. Fig. 1B) or a specifically adapted cross-section.

The air openings 6 may have a circular or slot-like shape, for example.

By means of the specific configuration of the air distribution manifold 51 and/or the positions of the air openings 6, the devices 3 located within the enclosure 2 of the electric power converter 1 can be cooled locally in a highly efficient manner such that a specific cooling of the hotspots created by the devices 3 can be obtained. In particular, each of the heat generating devices 3 can be cooled using an appropriate air flow rate.

If appropriate, a casing may be formed around one or more of the devices 3 and be connected to one or more of the air openings 6 of the air distribution manifold 51 in order to isolate the cooling of the specific device(s) 3 in the casing from other components or devices 3.

As illustrated in Figure 1B, a portion of the air distribution manifold 51 and/or a portion of the air collector manifold 52 may be integrated into a wall 25 of the enclosure 2. In Figure 1B, the wall 25 comprising the enclosure is a top plate of the enclosure. However, the wall 25 may also be any other wall such as a side wall of the enclosure. For example, the wall 25 is made from a plastics material.

Alternatively, the air distribution manifold 51 and/or the air collector manifold 52 may be formed separately from the wall 25.

The air mover 41 may comprise a fan, a blower or a compressor, for example.

The air cooling described significantly reduces the total amount of air flow required to keep the temperature of the devices 3 within the enclosure 2 under safe limits because the air flow can be focused on the hotspots occurring within the enclosure 2 during operation.

Compared to air cooling using a conventional fan, where the air substantially flows along one direction, shadowing effects behind comparably large components may be avoided.

Thus, the described air cooling provides more flexibility in component placements for higher power density and higher efficiency. Further, it is not necessary to provide individual fans for cooling a specific hotspot. This helps to reduce the number of fans needed for efficient cooling. This also helps to lower the acoustics signature for the electric power converter 1.

Within the enclosure 2, fans are not required for the air cooling so that the thickness of the enclosure 2 can be reduced.

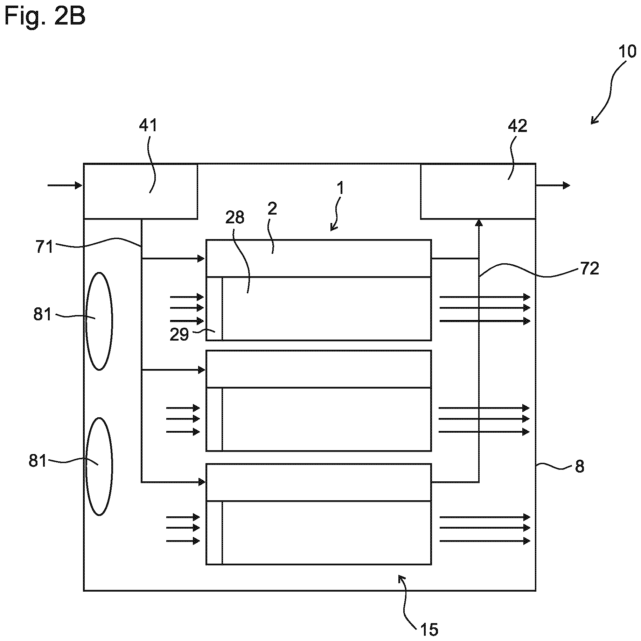

The electric power converter 1 may comprise further components located outside the airtight enclosure 2. This will be described in more detail in connection with Figure 2B.

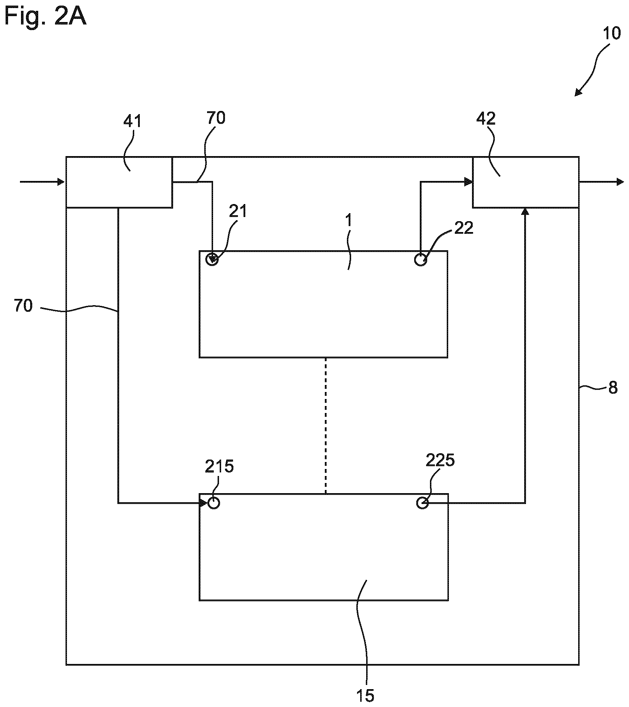

Figure 2A illustrates an exemplary embodiment of an electric appliance 10 with a plurality of electric power converters 1 that may be embodied as described in connection with Figures 1A to 1C, for example. For easier representation, the figure shows one electric power converter 1 and a further electric power converter 15 with a further air inlet opening 215 and a further air outlet opening 225.

However, the number of electric power converters 1 within a cabinet 8 of the electric appliance 10 can be varied in wide ranges. For example, the number of electric power converters 1 is in a range from 1 to 50.

As illustrated in Figure 2A, the air inlet opening 21 of electric power converter 1 and the further air inlet opening 215 of the further electric power converter 15 are connected to the same air mover 41. For example, this may be obtained via separate hoses 70.

Similarly, the air outlet opening 22 of the electric power converter 1 and the further air outlet opening 225 of the further electric power converter 15 are connected to the same further air mover 42.

In the schematic representation of Figure 2A, the air mover 41 and the further air mover 42 are located within the cabinet 8. However, the air mover 41 and the further air mover 42 may be located outside the cabinet 8 as well.

Thus, a single air mover 41 or a pair of air movers 41, 42 is sufficient to supply two or more electric power converters 1 or all of the electric power converters 1 of the electric appliance 10 with air to cool the devices 3 located within the airtight enclosure 2.

If the air mover 41 is located outside the cabinet 8 it may be in the same room as the electric appliance or in a different room or in a container or inside an air-conditioned room, for example. By protecting the air mover's air inlet from water ingression, all of the electric power converters 1 connected to the air mover can indirectly be protected from water ingression. This likewise applies to dust or other solid particles. Thus, a high solid and water ingress protection can be achieved for the electric power converters 1 of the electric appliance 10 in a very efficient way.

In particular, the electric power converters 1 themselves do not require any filters. If necessary, a single filter may be placed at the air mover's inlet, for example.

As fans are not required within the enclosure 2 of the electric power converter 1, costs for servicing or replacing fans can be eliminated.

Further, the quality of the air use can be easily controlled since a single global air inlet of the electric appliance 10 may be sufficient to provide the air to the individual air inlet openings 21 of the electric power converters 1.

If the air mover 41 comprises a compressor, the cooling efficiency can be further improved by utilizing the cooling effect of expanding air.

Liquid-based cooling systems are not required within the enclosure 2.

However, a water-cooling system may be used outside the enclosure 2 of the electric power converter 1. For example, water cooling may be used to precool the air before it is fed to the air inlet openings 21 of the electric power converter 1.

The exemplary embodiment of Figure 2B substantially corresponds to the exemplary embodiment of Figure 2A. In departure therefrom the electric power converter 1 comprises a section 28 located outside the enclosure 2. For example, the section 28 may comprise an active cooling device 29 such as a fan or a plurality of fans in order to further increase the cooling of the devices 3 located within the enclosure 2.

Alternatively or in addition, the section 28 may comprise one or more further electric or electronic devices or other components that need not be located within the enclosure and/or one or more heat sinks.

Further, the cabinet 8 may comprise fans 81 to provide the section 28 with fresh air.

The electric power converter 1 with the section 28 described in connection with Figure 2B may also be used for the further exemplary embodiments of the electric appliance 10.

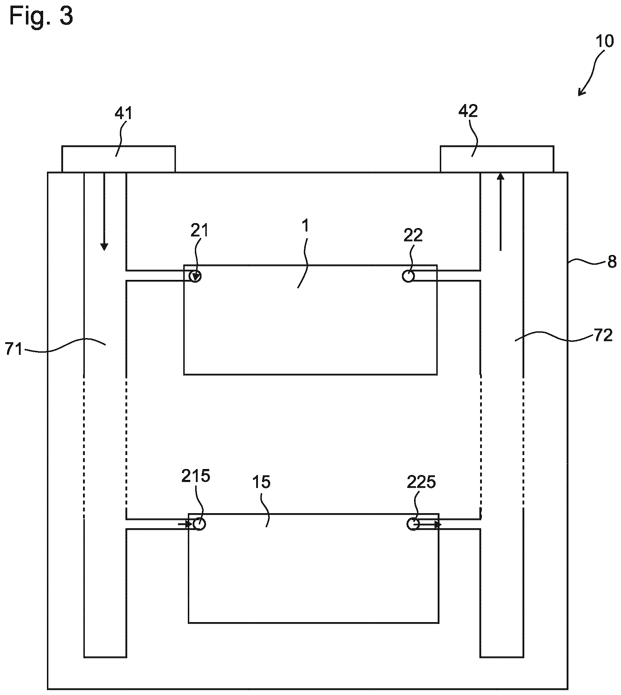

The exemplary embodiment of Figure 3 substantially corresponds to the exemplary embodiment of Figure 2A. In departure therefrom the air mover 41 is connected to the air inlet opening 21 of the electric power converter 1 and to the further air inlet opening 215 of the further electric power converter 15 via an air inlet manifold 71.

Likewise, the air outlet opening 22 of the electric power converter 1 and the further air outlet opening 225 of the further electric power converter 15 are connected to the further air mover 42 via an air outlet manifold 72. The air inlet manifold 71 and the air outlet manifold 72 may be arranged in part or completely within the cabinet 8 of the electric appliance 10.

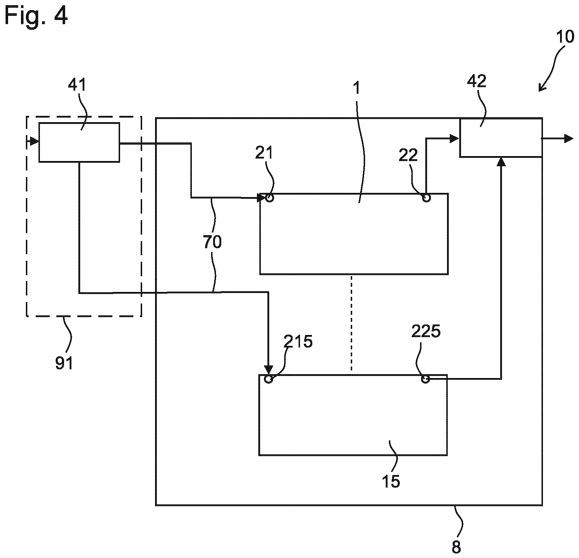

Figures 4 to 6 illustrate different configurations for the air cooling system that may be used for the electric appliance 10 described above. In the exemplary embodiment of Figure 4, the air cooling system is configured as an open loop air cooling system.

In this case the air mover 41 may be located within a conditioned air space 91. Thus, the electric appliance 10 comprises a conditioned air inlet and a hot air exhaust. For example, the conditioned air space 91 may be used to provide cooled and/or dried air compared to the air of the environment.

However, the conditioned air space 91 may also be omitted so that the electric appliance 10 with an open loop cooling system may be configured as described in connection with Figure 2A, for instance.

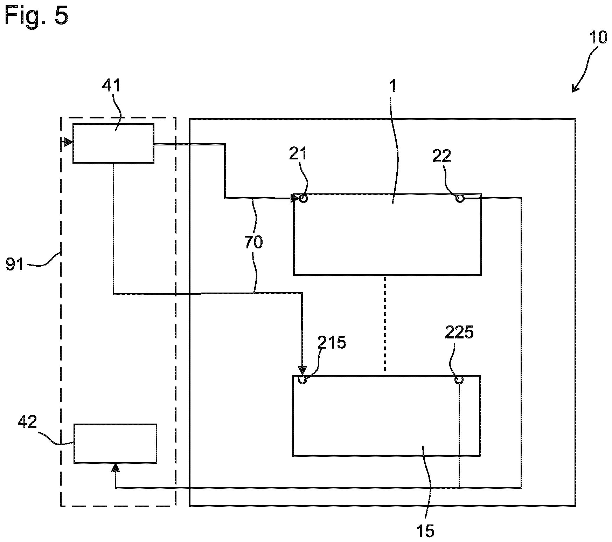

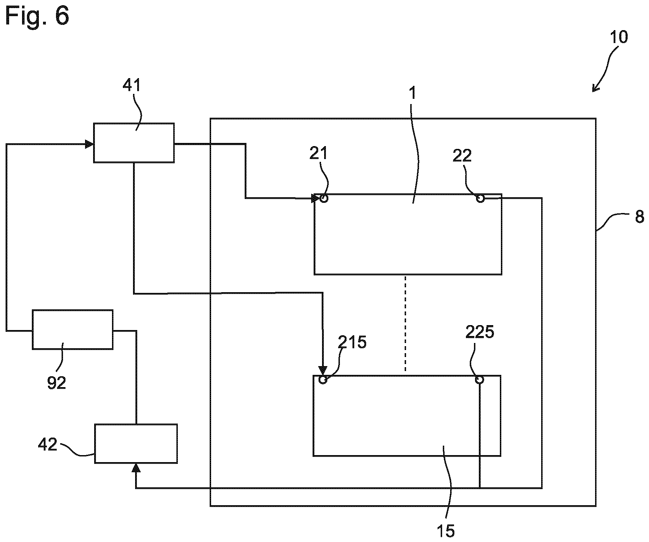

In the exemplary embodiments of Figures 5 and 6, the cooling system is configured as a closed loop air cooling system.

In the exemplary embodiment of Figure 5, the air mover 41 and the further air mover 42 are located in a conditioned air space 91.

In the exemplary embodiment of Figure 6, a heat exchanger 92 is arranged between the further air mover 42 and the air mover 41. Thus, the hot air coming from the further air mover 42 may be cooled via the heat exchanger 92 before it is fed back to the air inlet openings 21 of the electric power converter 1 via the air mover 41.

The different types of cooling systems described in connection with Figures 4 to 6 may also be used for the other exemplary embodiments of the electric appliance 10 described above.

The embodiments shown in the Figures 1 to 6 as stated represent exemplary embodiments of the improved electric power converter and the electric appliance; therefore, they do not constitute a complete list of all embodiments according to the improved electric power converter and the electric appliance. Actual configurations may vary from the embodiments shown in terms of arrangements, devices, and further components, for example.

### Reference Signs

- 1: electric power converter
- 10: electric appliance
- 15: further electric power converter
- 2: enclosure
- 21: air inlet opening
- 215: further air inlet opening
- 22: air outlet opening
- 225: further air outlet opening
- 23: valve
- 25: wall
- 28: section
- 29: active cooling device
- 3: device
- 41: air mover
- 42: further air mover
- 51: air distribution manifold
- 52: air collector manifold
- 6: air opening
- 70: hose
- 71: air inlet manifold
- 72: air outlet manifold
- 8: cabinet
- 81: fan
- 91: conditioned air space
- 92: heat exchanger

## Claims

1. An electric power converter (1) comprising an enclosure (2) and a plurality of devices (3) that generate heat during operation and are located inside the enclosure (2),
wherein
- and enclosure (2) comprises an air inlet opening (21) and an air outlet opening (22),
- the enclosure (2) is airtight except for the air inlet opening (21) and the air outlet opening (22),
- the air inlet opening (21) is configured to be connected to an air mover (41) creating a positive pressure,
- an air distribution manifold (51) is located inside the enclosure (2) and connected to the air inlet opening (21),
and
- the air distribution manifold (51) has air openings (6) directed towards the devices (3).

2. The electric power converter according to claim 1, wherein the air outlet opening (22) is configured to be connected to a further air mover (42) creating a negative pressure.

3. The electric power converter according to claim 1 or 2, wherein an air collector manifold (52) is placed inside the enclosure (2) and connected to the air outlet opening (22).

4. The electric power converter according to any one of the preceding claims,
wherein at least a portion of the air distribution manifold (51) is formed in a wall (25) of the enclosure (2).

5. The electric power converter according to any one of the preceding claims,
wherein the electric power converter (1) is free of fans located within the enclosure (2).

6. The electric power converter according to any one of the preceding claims,
wherein the electric power converter (1) further comprises a section (28) located outside the enclosure (2).

7. The electric power converter according to claim 6, wherein the section (28) comprises an active cooling device (29).

8. An electric appliance comprising a cabinet (8), an electric power converter (1) according to any one of the preceding claims arranged in the cabinet (8), and an air mover (41) connected to the air inlet opening (21) of the electric power converter (1).

9. The electric appliance according to claim 8,
wherein the air mover (41) is part of an open loop air cooling system.

10. The electric appliance according to claim 9,
wherein the open loop air cooling system comprises a conditioned air space (91).

11. The electric appliance according to claim 8,
wherein the air mover (41) is part of a closed loop air cooling system.

12. The electric appliance according to claim 11,
wherein the closed loop air cooling system comprises a heat exchanger (92).

13. The electric appliance according to any one of claims 8 to 12,
wherein the electric appliance comprises a further electric power converter (1) with a further air inlet opening (215), wherein the air inlet opening (21) of the electric power converter (1) and the further air inlet opening (215) of the further electric power converter (15) are connected to the air mover (41).

14. The electric appliance according to any one of claims 8 to 13,
wherein the electric appliance (10) is configured to provide the air inlet opening (21) of the electric power converter (1) with conditioned air.

15. The electric appliance according to any one of claims 8 to 14,
wherein the electric appliance (10) is configured to provide the air inlet opening (21) of the electric power converter (1) with compressed air.
